Europäisches Patentamt

European Patent Office

Office européen des brevets

(11) Numéro de publication: **0 324 678**
A1

# (12) DEMANDE DE BREVET EUROPEEN

(21) Numéro de dépôt: 89400067.8

(22) Date de dépôt: **10.01.89**

(51) Int. Cl.⁴: **H 04 N 3/15**
H 01 L 27/14

(30) Priorité: 15.01.88 FR 8800413

(43) Date de publication de la demande:
**19.07.89 Bulletin 89/29**

(84) Etats contractants désignés: **DE GB NL**

(71) Demandeur: **THOMSON-CSF**
**51, Esplanade du Général de Gaulle**
**F-92800 Puteaux (FR)**

(72) Inventeur: **Arques, Marc**
**THOMSON-CSF SCPI 19, avenue de Messine**
**F-75008 Paris (FR)**

(74) Mandataire: **Guérin, Michel et al**
**THOMSON-CSF SCPI**
**F-92045 PARIS LA DEFENSE CEDEX 67 (FR)**

(54) Matrice photosensible à deux diodes et une capacité par point, sans remise à niveau optique.

(57) L'invention concerne les matrices d'éléments photosensibles.

Pour éviter la nécessité d'une source lumineuse de remise à niveau dans les matrices utilisant comme point photosensible une photodiode en série avec une capacité entre un conducteur de ligne et un conducteur de colonne, on propose selon l'invention de prévoir un point photosensible composé de deux diodes (diode photosensible DP, diode de lecture DL) et une capacité (CS) reliées à un noeud commun flottant (A). La capacité est reliée à un conducteur d'adressage de ligne (LRi) fournissant une impulsion de lecture à la ligne sélectionnée; la cathode de la diode de lecture est reliée au conducteur de colonne (Cj) qui recueille le signal utile; et l'anode de la photodiode est reliée à un deuxième conducteur de ligne (qui peut d'ailleurs être le premier conducteur d'une ligne voisine) qui reçoit une impulsion de remise à niveau après l'impulsion de lecture. Dans une autre réalisation, la photodiode est reliée simplement à une source de tension de référence (VR).

FIG.1

## Description

## MATRICE PHOTOSENSIBLE A DEUX DIODES ET UNE CAPACITE PAR POINT, SANS REMISE A NIVEAU OPTIQUE

L'invention concerne les matrices d'éléments photosensibles.

Pour réaliser des matrices d'éléments photosensibles, il est classique de prévoir un réseau de conducteurs en ligne, et un réseau de conducteurs en colonne, avec, à chaque croisement d'une ligne et d'une colonne, un élément photosensible respectif. Par le réseau de lignes on sélectionne une ligne d'éléments photosensibles dont on veut connaître les signaux électriques de sortie; par le réseau de conducteurs de colonnes, on lit un signal de sortie respectif pour chacun des éléments de la ligne sélectionnée.

Dans la demande de brevet français 86 00716, on a décrit une matrice photosensible comportant un réseau de points photosensibles dans lequel chaque point photosensible comprend une capacité de stockage de charges en série avec un élément photosensible, l'ensemble étant connecté entre un conducteur de ligne et un conducteur de colonne; l'élément photosensible peut être une photodiode PIN à trois couches (couche semiconductrice de type P, couche intrinsèque I, couche de type N).

Des charges sont engendrées dans la photodiode par l'éclairement du point photosensible. Elles s'accumulent sur le noeud (flottant) entre la photodiode et la capacité. Elles sont lues par application au conducteur de ligne d'une impulsion de tension dans un sens qui polarise la photodiode en direct (alors qu'elle était polarisée en inverse pendant la phase d'accumulation). Des charges en quantité correspondant aux charges accumulées sont alors transférées du noeud flottant vers la colonne (ou inversement de la colonne vers le noeud flottant); la lecture consiste à mesurer ce mouvement de charges.

Après la fin de l'impulsion de lecture, la photodiode se bloque pour une nouvelle phase d'éclairement et d'intégration de charges.

Mais le potentiel du noeud flottant n'est plus à la valeur qu'il avait au début de la phase d'intégration; on ne peut donc pas comencer une nouvelle phase d'intégration sans établir à une valeur de départ bien déterminée ce potentiel du noeud flottant.

La phase de lecture est donc suivie d'une phase de remise à niveau du potentiel du noeud flottant.

La remise à niveau se fait par éclairement intense de la photodiode. Il est donc nécessaire de prévoir une source d'éclairement intense et des moyens de commande synchronisés avec les moyens de lecture de la matrice photosensible pour effectuer une remise à niveau après chaque phase de lecture.

D'autre part, les matrices décrites ci-dessus, utilisant comme point photosensible un ensemble en série d'une photodiode et d'une capacité, nécessitent que l'éclairement soit discontinu, c'est-à-dire que la matrice soit dans l'obscurité pendant le temps réservé à la lecture du signal fourni par les points photosensibles.

La présente invention propose une nouvelle structure de point photosensible qui élimine la nécessité d'une source d'éclairement de remise à niveau et qui permet d'acquérir l'information en flux continu sans qu'il soit nécessaire de mettre la matrice dans l'obscurité pendant la lecture.

Selon l'invention, on propose une matrice de points photosensibles comportant un réseau de points photosensibles agencés en lignes (au moins une ligne) et en colonnes (au moins une colonne), chaque point photosensible étant situé au carrefour d'une ligne et d'une colonne, caractérisé en ce que chaque point photosensible comprend deux diodes et une capacité reliées à un noeud flottant, la capacité étant reliée entre un conducteur de ligne et le noeud flottant, une première diode, dite diode de lecture, connectée entre le noeud flottant commun et un conducteur de colonne pour permettre le transfert entre ce conducteur de colonne et le noeud flottant d'une quantité de charges générées sur le noeud flottant par l'éclairement du point photosensible, et une deuxième diode, dite diode photosensible, connectée entre le noeud flottant et un conducteur relié à une source de tension de remise à niveau, pour d'une part engendrer lorsqu'elle est éclairée des charges électriques sur le noeud flottant et d'autre part rétablir à une valeur choisie le potentiel du noeud flottant après ledit transfert de charges.

On prévoit de préférence que l'anode de la diode de lecture et la cathode de la diode photosensible sont reliées au noeud flottant, ou inversement que la cathode de la diode de lecture et l'anode de la diode photosensible sont reliées au noeud flottant.

Dans une réalisation particulière, la source de remise à niveau est une source de potentiel de référence fixe.

Dans cette réalisation, non seulement il n'y a pas besoin de source de lumière pour remettre à niveau le potentiel du noeud flottant, mais il n'y a pas besoin d'appliquer une impulsion de remise à niveau sur un conducteur de remise à niveau spécifique pour chaque ligne. La remise à niveau se fera par l'action conjuguée de la source de tension constante (commune à toute la matrice) et d'une impulsion de remise à niveau appliquée sur le conducteur de ligne après chaque phase de lecture.

Dans une autre réalisation, le conducteur relié à la source de tension de remise à niveau est un autre conducteur de ligne; un moyen est prévu pour appliquer sur le conducteur de ligne relié à la capacité une impulsion de lecture à la fin d'une période d'intégration de charges; un autre moyen est prévu pour appliquer sur l'autre conducteur de ligne une impulsion de tension de remise à niveau après l'impulsion de lecture.

Cette disposition a l'avantage de permettre que la charge lue sur une colonne est d'autant plus forte que l'éclairement est plus faible, et également l'avantage de permettre le transfert d'une charge minimale non nulle dans tous les cas d'éclairement (d'un éclairement nul à un éclairement de saturation).

On peut aussi prévoir que l'autre conducteur de ligne mentionné est le conducteur de ligne relié à la capacité d'un point photosensible correspondant à une autre ligne de points photosensibles de la matrice. Dans certains cas, cette autre ligne sera adjacente à la première, mais on peut aussi envisager qu'elle ne le soit pas, en particulier dans des cas où on veut pouvoir faire une lecture de la matrice avec un balayage entrelacé des lignes. Ces réalisations permettent d'éviter d'avoir deux conducteurs de ligne pour chaque point de la matrice.

Enfin, dans certains cas, on effectuera la lecture par application d'une impulsion de lecture sur une ligne, toutes les colonnes étant à un potentiel de référence; mais dans d'autres cas, on pourra appliquer sur une ligne une impulsion de lecture d'un signe par rapport au potentiel de référence des colonnes et simultanément une impulsion de lecture de signe opposé sur un conducteur de colonne spécifié relié au point photosensible dont on veut lire les charges, les autres conducteurs de colonne étant maintenus au potentiel de référence. Cette disposition permet de sélectionner facilement une colonne de points photosensibles.

L'invention est applicable à toutes sortes de matrices photosensibles, y compris celles qui sont utilisées en radiologie et qui comportent de ce fait un scintillateur (oxyde de gadolinium, iodure de césium, etc.) pour convertir un rayonnement X (ou gamma, ou neutronique, etc.) en rayonnement lumineux dans la bande de longueurs d'onde auxquelles les photodiodes sont sensibles.

L'invention se prête particulièrement à une réalisation dans laquelle les points photosensibles sont réalisés par superposition de couches de silicium amorphe.

Parmi les avantages que l'on escompte de la présente invention, car ils sont essentiels pour la qualité des matrices réalisées, on peut mentionner:
- la faible capacité des colonnes de points photosensibles,
- la rapidité de la lecture,
- le bon découplage entre les points photosensibles de lignes ou colonnes voisines,
- la réduction de bruit parasite au moment de la lecture, bruit qui pouvait être généré dans les systèmes antérieurs par la mise en conduction directe de la diode photosensible; ici, la photodiode reste en principe polarisée en inverse, même pendant la lecture.

D'autres caractéristiques et avantages de l'invention apparaîtront à la lecture de la description détaillée qui suit et qui est faite en référence aux dessins annexés dans lesquels:

- La figure 1 représente une matrice de points photosensibles selon l'invention;
- la figure 2 représente les diagrammes temporels de variation des potentiels respectivement sur le premier conducteur de ligne, le deuxième conducteur de ligne et le noeud commun flottant, pour le mode de réalisation de la figure 1;
- la figure 3 représente une courbe de variation de la quantité de charges lues sur la colonne en fonction de l'éclairement;
- la figure 4 représente des diagrammmes temporels de potentiels pour une variante de fonctionnement du circuit de la figure 1;
- la figure 5 représente la courbe de variation de la quantité de charges lues en fonction de l'éclairement, pour le mode de fonctionnement de la figure 4.
- la figure 6 représente une variante de réalisation utilisant le mode de fonctionnement de la figure 4;
- la figure 7 représente un autre mode de réalisation de la matrice photosensible selon l'invention, dans lequel la remise à niveau après lecture se fait non pas par une impulsion de tension mais par une source de tension continue;
- la figure 8 est un diagramme temporel explicatif montrant les variations de potentiel dans le mode de réalisation de la figure 7;
- la figure 9 représente un diagramme temporel de la succession des phases de commande des différentes lignes de la matrice.

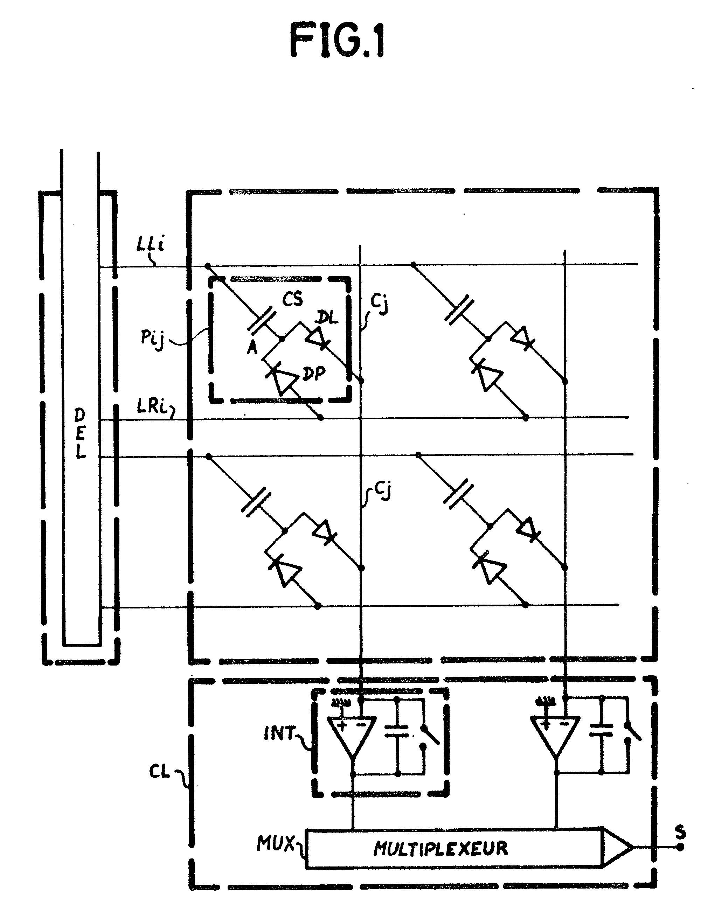

Sur la figure 1, on voit un schéma simplifié d'une matrice de points photosensibles selon un mode de réalisation de la présente invention.

La matrice comprend un réseau de lignes et de colonnes de points photosensibles Pij.

Chaque ligne comprend en fait deux conducteurs de ligne LLi et LRi auxquels sont raccordés les points photosensibles de cette ligne; le conducteur de ligne LLi sert à fournir une impulsion de tension de lecture des points de cette ligne; le conducteur de ligne LRi sert à fournir une impulsion de remise à niveau avant une nouvelle phase d'intégration. Les conducteurs de ligne sont connectés à un décodeur de ligne DEL apte à sélectionner une ligne déterminée dont on veut lire les points; le décodeur de ligne DEL autorise la transmission d'impulsions de lecture et de remise à niveau sur les conducteurs LLi et LRi, respectivement, de la ligne sélectionnée.

Chaque colonne comprend un conducteur de colonne Cj auquel sont raccordés les points photosensibles de cette colonne; le conducteur de colonne Cj est relié à un circuit CL de lecture des charges générées par le point photosensible Pij situé à l'intersection de cette colonne et de la ligne sélectionnée.

Dans un exemple de réalisation, le circuit de lecture comprend un intégrateur INT pour chacune des colonnes de points, et un multiplexeur MUX recevant les sorties des intégrateurs pour fournir sur sa sortie S successivement des signaux représentant l'éclairement des points successifs de la ligne désignée.

Dans d'autres cas, le circuit de lecture pourrait être un circuit à transfert de charges et le multiplexeur pourrait être un registe à décalage à transfert de charges.

Selon l'invention, chaque point photosensible Pij comprend deux diodes et une capacité reliées à un noeud flottant commun A :
- DP (diode dont la caractéristique principale est d'être photosensible);
- DL (diode de lecture permettant le transfert de charges du noeud flottant A vers le conducteur de colonne Cj);
- CS (capacité de stockage des charges générées par l'éclairement).

Dans le mode de réalisation de la figure 1, la diode photosensible DP est connectée entre le deuxième conducteur· de ligne LRi et le noeud flottant A, la diode de lecture DL est connectée entre le conducteur de colonne et le noeud flottant, et la capacité est connectée entre le premier conducteur de ligne LLi et le noeud flottant.

Plus précisément, dans l'exemple de la figure 1, c'est la cathode de la diode photosensible DP et l'anode de la diode de lecture DL qui sont connectées au noeud flottant; mais on peut prévoir de manière équivalente, à condition d'inverser les sens relatifs des potentiels mis en jeu sur les conducteurs de ligne et de colonne, une inversion des anodes et cathodes des deux diodes; dans ce cas, on aurait l'anode de la diode photosensible et la cathode de la diode de lecture connectées au noeud flottant.

La diode DP est de surface relativement importante pour que sa sensibilité soit suffisante; la diode de lecture est plus petite et est de préférence mise dans l'obscurité, car elle risquerait, si elle était éclairée, de retrancher des charges du signal utile stocké sur le noeud flottant.

La capacité de la colonne de points sera d'autant plus faible (ce qui est avantageux) que la capacité de la diode de lecture sera faible, ce qui incite à prendre pour DL une diode de petites dimensions.

## FONCTIONNEMENT DU SCHEMA DE LA FIGURE 1

Pour simplifier les explications, on supposera que la capacité des diodes DL et DP est faible devant celle de la capacité de stockage CS; s'il n'en était pas ainsi, les valeurs numériques de potentiels et de variations de potentiel indiqués au cours des explications seraient modifiées, mais le principe de fonctionnement resterait valable.

On négligera aussi les chutes de potentiel dans les diodes lorsqu'elles sont polarisées en direct, alors que ces chutes sont de l'ordre de 0,5 volt.

Enfin, on supposera que le circuit de lecture connecté aux colonnes maintient le potentiel de celles-ci à une valeur de référence nulle.

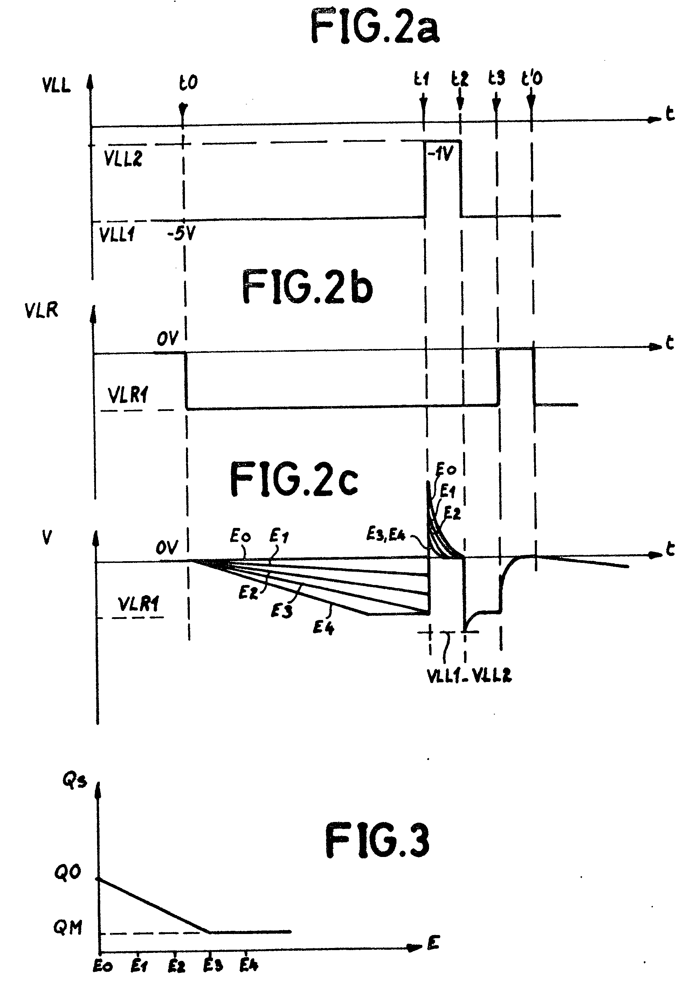

La figure 2 représente des diagrammes temporels permettant d'illustrer le fonctionnement.

Le cycle de fonctionnement périodique dure entre un instant t0 et un instant t'0.

Au départ, juste avant l'instant t0, l'état initial est le suivant (figure 2, diagramme 2a, 2b, 2c):
- le potentiel VLL sur le premier conducteur de ligne LLi a une valeur VLL1, par exemple -5 volt;
- le potentiel VLR sur le deuxième conducteur de ligne LRi a une valeur nulle;
- le potentiel VA sur le noeud A a une valeur nulle.

On verra que c'est bien la situation qui va exister à la fin du cycle de lecture qu'on va maintenant décrire.

Au temps t0, on applique sur le deuxième conducteur de ligne LRi de la ligne sélectionnée un potentiel négatif VLR1, par exemple de -3 volts.

Comme la capacité de la diode DP est faible devant celle de la capacité CS, le potentiel du noeud A ne varie presque pas sous l'effet de cette commutation de tension (il varie cependant négativement suffisamment pour bloquer la diode de lecture DL).

Du temps t0 jusqu'au temps t1, la photodiode DP éclairée engendre des charges (ici des électrons) qui viennent s'accumuler sur le noeud A, faisant baisser le potentiel de ce noeud en proportion de l'éclairement. Les charges ne peuvent s'évacuer par aucune des diodes car elles sont toutes deux polarisées en inverse (du moins tant que le potentiel du noeud A ne descend pas au dessous du potentiel du conducteur LRi, c'est-à-dire -3 volts).

Le diagramme de la figure 2c montre ce qui se passe pour divers niveaux d'éclairment:
- niveau E0, éclairement nul,
- niveau E1, éclairement faible,
- niveau E2, éclairement moyen,
- niveau E3, éclairement maximal lisible,
- niveau E4, éclairement trop fort: saturation.

L'éclairement maximal E3 est l'éclairement tel qu'à la fin de la période d'intégration de charges, au temps t1 où commence la lecture proprement dite, le potentiel du point A atteint le niveau négatif VLR1.

Au delà de cet éclairement E3, la diode photosensible DP passe en direct et le potentiel du noeud A ne peut plus descendre (saturation), produisant ainsi un effet d'antiéblouissement.

A l'instant t1, qui marque la fin du temps d'intégration, on applique sur le premier conducteur de ligne LLi une impulsion de lecture (figure 2a); cette impulsion fait passer brusquement le potentiel VLL de ce conducteur de la valeur VLL1 à une valeur VLL2 supérieure à VLL1 (par exemple -1 volt). Le potentiel du noeud flottant A monte alors brusquement (diagramme 2c) d'une valeur correspondant à l'augmentation de la tension VLL, c'est à dire d'une valeur (VLL2 - VLL1). Cette montée brusque est faite par couplage capacitif à travers la diode DP.

Si on s'arrange pour que l'amplitude (VLL2 - VLL1) de l'impulsion de lecture soit supérieure à la valeur absolue de la tension VLR1 appliquée au deuxième conducteur de ligne, on voit que le potentiel du noeud A deviendra toujours positif à l'instant t1 quel que soit le niveau d'éclairement pendant l'intervalle t0, t1 (diagramme 2c).

La diode de lecture devient donc systématiquement conductrice puisque le potentiel du conducteur de colonne est égal à zéro. De ce fait, les charges stockées sur le noeud flottant s'évacuent à travers la diode de lecture vers le conducteur de colonne et engendrent un signal dans le circuit de lecture CL.

A mesure de cette évacuation, le potentiel du noeud flottant A descend et revient à zéro; cette descente est rapide et doit être terminée à la fin de l'impulsion de lecture, c'est-à-dire au temps t2. Le diagramme 2c représente le retour à zéro du potentiel du noeud A en fonction du niveau d'éclairement qui avait été reçu par la photodiode DP.

Au temps t2 qui marque la fin de l'impulsion de lecture, le potentiel du premier conducteur de ligne revient à sa valeur de départ VLL1, entraînant sur le

noeud A (redevenu flottant puisqu'aucune diode n'est polarisée en direct à ce moment) une chute brutale de potentiel d'une amplitude égale à VLL2 - VLL1 (diagramme 2c, temps t2).

La chute brutale du potentiel du noeud A de zéro à une valeur VLL2 - VLL1 rend la photodiode DP momentanément conductrice, ce qui ramène le potentiel du noeud A à la valeur VLR1 du potentiel du deuxième conducteur de ligne LRi.

Au temps t3 commence la phase de remise à niveau du potentiel du noeud A. Cette remise à niveau est nécessaire pour revenir aux conditions de départ dans lesquelles le potentiel du noeud A était nul.

La remise à niveau est faite par une impulsion de remise à niveau appliquée au deuxième conducteur de ligne LRi dont le potentiel VLR1 n'a pas varié depuis le début du cycle. L'impulsion est une impulsion positive d'amplitude VLR1, c'est à dire qu'elle ramène à zéro le potentiel du conducteur de ligne. Cette impulsion commence au temps t3; elle se termine à l'instant t'0 de départ d'un nouveau cycle de lecture.

On peut remarquer ici que l'impulsion de remise à niveau peut commencer avant la fin de l'impulsion de lecture pourvu qu'elle ne commence pas avant que le potentiel du point A ne soit repassé d'une valeur positive à zéro et pourvu qu'elle se termine après l'impulsion de lecture.

tL'impulsion de remise à niveau a pour effet de ramener à zéro le potentiel du noeud A puisque la photodiode est alors polarisée en direct (diagramme 2c). Le potentiel du noeud A reste alors à zéro jusqu'à la fin de l'impulsion de remise à niveau, c'est-à-dire jusqu'au temps t'0 où débute un nouveau cycle d'intégration de charges.

La figure 3 représente un diagramme de valeur de la charge recueillie sur la colonne Cj pendant l'impulsion de lecture, en fonction de l'éclairement reçu pendant la période d'intégration t0,t1. Cette charge est proportionnelle à l'intégrale de la variation du potentiel du point A pendant l'impulsion de lecture; la variation est visible sur le diagramme 2c de la figure 2.

Sur la figure 3, on voit que le signal utile Qs est linéaire pour un éclairement variant entre l'éclairement nul E0 et l'éclairement maximal E3; au delà, il y a saturation et la charge lue est indépendante de l'éclairement.

Il est très intéressant de constater sur cette figure que la charge lue décroît avec l'éclairement; elle est maximale (Q0) pour un éclairement nul. Cela est très important car c'est généralement pour les faibles éclairements qu'on recueille des faibles charges qui sont plus difficiles à transférer (ou à transférer rapidement) que des charges plus importantes. Il est important aussi de constater que même pour l'éclairement maximal E3, la charge QM recueillie n'est pas nulle dès lors que la différence de potentiel VLL2 - VLL1 est supérieure en valeur absolue à VLR1. Par conséquent, on ne sera jamais dans la situation où une charge nulle doit être lue.

Le fonctionnement du cycle d'intégration de charges et lecture de ces charges a donc été complètement décrit pour une ligne de la matrice.

Les différentes lignes reçoivent successivement chacune une impulsion de lecture suivie d'une impulsion de remise à niveau, et ces impulsions sont décalées dans le temps d'une ligne à l'autre pour qu'il n'y ait pas simultanément deux lignes adressées en lecture/remise à niveau.

On peut remarquer que la capacité de la colonne est sensiblement égale (en tout cas pas supérieure) à la somme des capacités des diodes de lecture DL des lignes non adressées. Cette capacité est bien inférieure à ce qu'elle était dans l'art antérieur (point photosensible utilisant une photodiode en série avec une capacité) car la capacité de la diode DL peut être nettement plus faible que celle de la photodiode et la capacité de l'art antérieur.

VARIANTE DE FONCTIONNEMENT

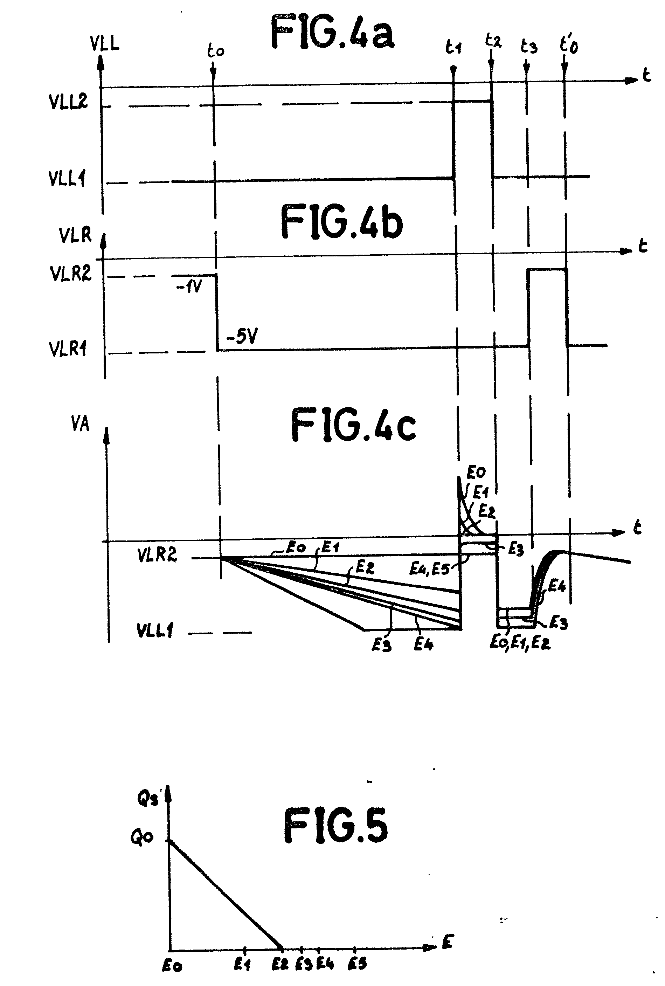

Dans une variante de réalisation, on modifie les potentiels de la manière représentée à la figure 4, c'est-à-dire que
- d'une part le potentiel le plus négatif VLR1 du deuxième conducteur de ligne LRi est égal au potentiel le plus négatif VLL1 du premier conducteur de ligne LLi,
- d'autre part, le potentiel le plus positif du deuxième conducteur (pendant l'impulsion de remise à niveau) n'est plus nul mais égal à une valeur VLR2 légèrement négative (par rapport au potentiel de colonne), de préférence égale au potentiel haut VLL2 de l'impulsion de lecture.

Il en résulte que les impulsions de lecture et de remise à niveau ont la même amplitude, et de plus elles ont le même niveau haut et le même niveau bas (voir diagrammes 4a et 4b de la figure 4).

On a représenté sur le diagramme 4c de la figure 4 les variations de potentiel du noeud A respectivement pour un éclairement nul E0, un éclairement moyen E1, un éclairement maximal mesurable E2, un éclairement plus important E3, et un éclairement élevé E4 pour lequel une fonction d'antiéblouissement entre en jeu.

Contrairement au cas de la figure 2, le potentiel du noeud A à l'instant t0 de démarrage du cycle d'intégration/lecture n'est pas nul mais égal à VLR2, valeur à laquelle il a été ramené par l'impulsion de remise à niveau précédente.

Pour les éclairement E0, E1, et E2, le fonctionnement est très semblable à celui qui a été expliqué à propos des figures 1 à 3, à l'exception du fait que pour l'éclairement E2, la charge transmise au conducteur de colonne Cj pendant l'impulsion de lecture est nulle: on ne bénéficie plus de la charge minimale QM visible à la figure 3.

Au delà de l'éclairement E2, l'impulsion de lecture ne fait plus passer au dessus de zéro le potentiel du noeud A et aucune charge ne peut plus se déverser sur la colonne Cj.

Le potentiel du noeud A reste donc pendant toute la durée de lecture à la valeur qu'il a atteinte à la fin de la période d'intégration, augmentée de VLL2 - VLL1.

A partir d'un niveau d'éclairement E4 correpondant à un potentiel négatif égal à VLL1 sur le noeud A, la fonction d'antiéblouissement entre en jeu, la diode DP passant en direct puis cessant de conduire.

L'impulsion de lecture consiste à faire monter brusquement d'une valeur VLL2 - VLL1 le potentiel du noeud flottant A; ce potentiel devient supérieur à zéro si l'éclairement est compris entre E0 et E2, ce qui rend conductrice la diode de lecture DL et qui transfère des charges du noeud A vers la colonne Cj.

La fin de l'impulsion de lecture ramène le potentiel du noeud A à une valeur VLL1 - VLR2 si l'éclairement était normal (entre E0 et E2) et à une valeur variable entre VLL1 et VLL1-VLL2 pour des éclairements supérieurs. De toutes façons, ce potentiel est ramené à sa valeur de départ VLR2 par l'application de l'impulsion de remise à niveau sur le deuxième conducteur de ligne.

L'impulsion de remise à niveau rend conductrice la photodiode DP et ramène le potentiel du noeud flottant à la valeur de potentiel VLR2 présente sur le conducteur de ligne LRi pendant cette impulsion.

Le cycle d'intégration suivant commence à l'instant t'0 marquant la fin de l'impulsion de remise à niveau.

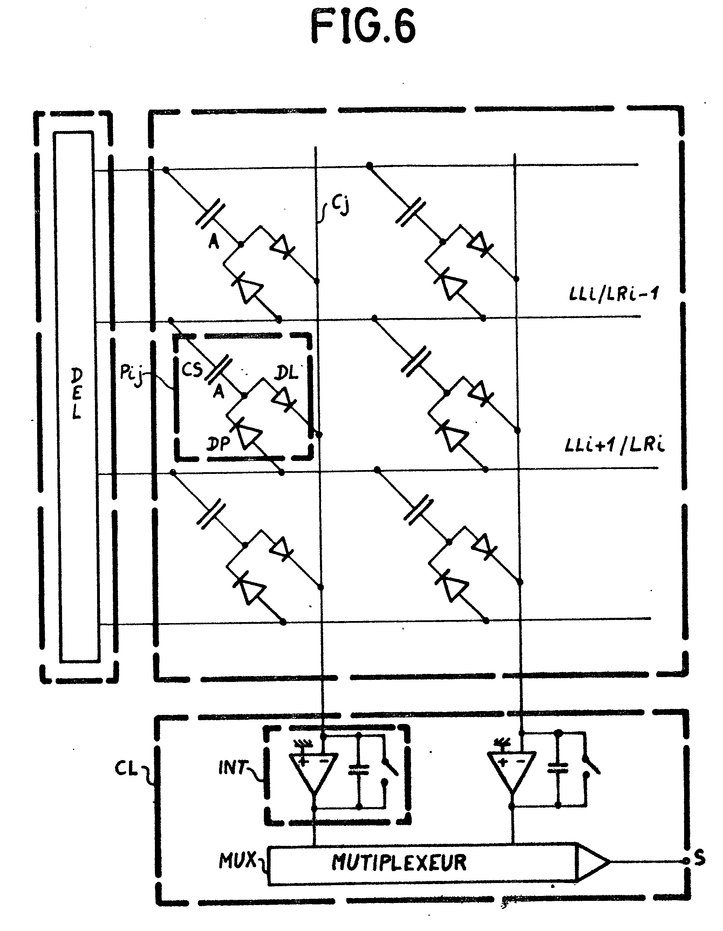

La figure 5 représente le diagramme de la charge lue sur la colonne Cj, c'est-à-dire l'intégrale de la variation de potentiel du noeud A pendant la durée de l'impulsion de lecture, en fonction de l'éclairement. La variation est linéaire, à pente négative, et la charge lue est maximale pour un éclairement nul. Il n'y a plus de charge minimale lue.

Le choix des potentiels VLL1, VLL2, VLR1, VLR2 qui a été fait dans le cas de la figure 3 présente un intérêt tout particulier du fait que l'impulsion de lecture est rigoureusement identique à une impulsion de remise à niveau, avec seulement un décalage dans le temps entre les deux.

La figure 6 représente un mode de réalisation qui met à profit cette particularité.

Sur la figure 6, on a regroupé en un seul conducteur de ligne le deuxième conducteur de ligne LRi de la ligne considérée et le premier conducteur de ligne LLi+1 de la ligne suivante. L'impulsion de remise à niveau de la première ligne sert d'impulsion de lecture pour la ligne suivante, et ainsi de suite.

Le circuit fonctionne exactement selon les explications données à propos de la figure 3. Comme l'impulsion de remise à niveau n'injecte aucune charge sur la colonne Cj mais seulement sur une ligne, il n'y a aucun inconvénient à ce que cette impulsion serve d'impulsion de lecture pour une autre ligne de points.

Le décodeur DEL qui sert à l'adressage des lignes devra appliquer séquentiellement à chaque ligne une impulsion jouant deux rôles.

Sur le schéma de la figure 6, le conducteur de ligne Li est partagé entre deux lignes adjacentes de points photosensibles, et les impulsions appliquées sur les lignes successives se succèdent dans l'ordre des lignes.

On peut noter que d'autres solutions sont possibles dans lesquels le conducteur de ligne issu du décodeur de ligne DEL est partagé entre deux lignes non adjacentes, auquel cas ce conducteur doit être dédoublé (mais il reçoit un signal unique constitué par une impulsion de lecture/remise à niveau). Cette disposition présente un intérêt pour des matrices dans lesquelles on veut pouvoir faire d'une part une sommation des signaux de plusieurs lignes et d'autre part un balayage entrelacé (balayage d'une ligne sur deux dans une première demi-trame et des autres dans la deuxième demi-trame). Cette disposition est utilisable par exemple si on veut lire des groupes de deux lignes adjacentes à la fois (en recueillant sur la colonne la somme des charges correspondant à ces deux lignes) ; et d'ailleurs, cette lecture de deux ou plusieurs lignes adjacentes à la fois peut être faite en balayage entrelacé: on lira un groupe de deux lignes, on sautera le deuxième, on lira le troisième etc., pendant une première demi-trame ; puis on sautera le premier groupe, on lira le deuxième, on sautera le troisième, etc., pendant la 2ème demi-trame. On utilise alors un conducteur de ligne partagé entre la première ligne et la cinquième, un autre partagé entre la deuxième et la sixième etc.

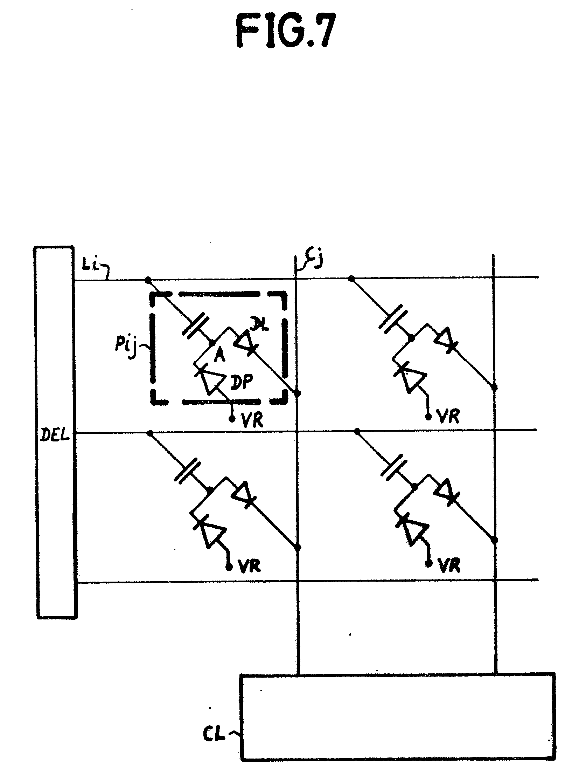

La figure 7 représente un autre mode de réalisation de l'invention. Le point photosensible est constitué exactement comme celui décrit à propos de la figure 1, mais le conducteur de remise à niveau (auquel est reliée la diode DP) n'est plus un conducteur commandé par un dispositif d'adressage de ligne; c'est au contraire un conducteur commun à tout le plan photosensible, et ce conducteur est porté en permanence à un potentiel fixe VR.

Les sens des deux diodes DP et DL pourraient être inversés simultanément pourvu qu'on change aussi les sens des potentiels.

La structure du point photosensible de la figure 7 se résume donc très simplement à deux diodes et une capacité reliées au noeud commun A, avec :
- La capacité CS reliée à un conducteur de ligne Li lui-même relié à une sortie d'un décodeur de ligne ; le décodeur permet de fournir périodiquement une impulsion de lecture à une ligne désignée de la matrice;
- cathode de la diode de lecture DL reliée comme auparavant au conducteur de colonne Cj sur lequel on veut recueillir le signal engendré par le point photosensible;
- anode de la diode photosensible DP reliée à une source de tension de référence VR.

La diode de lecture DL est de préférence petite et autant que possible placée dans l'obscurité.

FONCTIONNEMENT DU SCHEMA DE LA FIGURE 7

On supposera pour simplifier l'explication, que les capacités des diodes DP et DL sont faibles devant celle de la capacité CS. Cela veut dire que toute variation de tension appliquée brutalement au conducteur de ligne Li se retrouve immédiatement et pratiquement intégralement sur le point A.

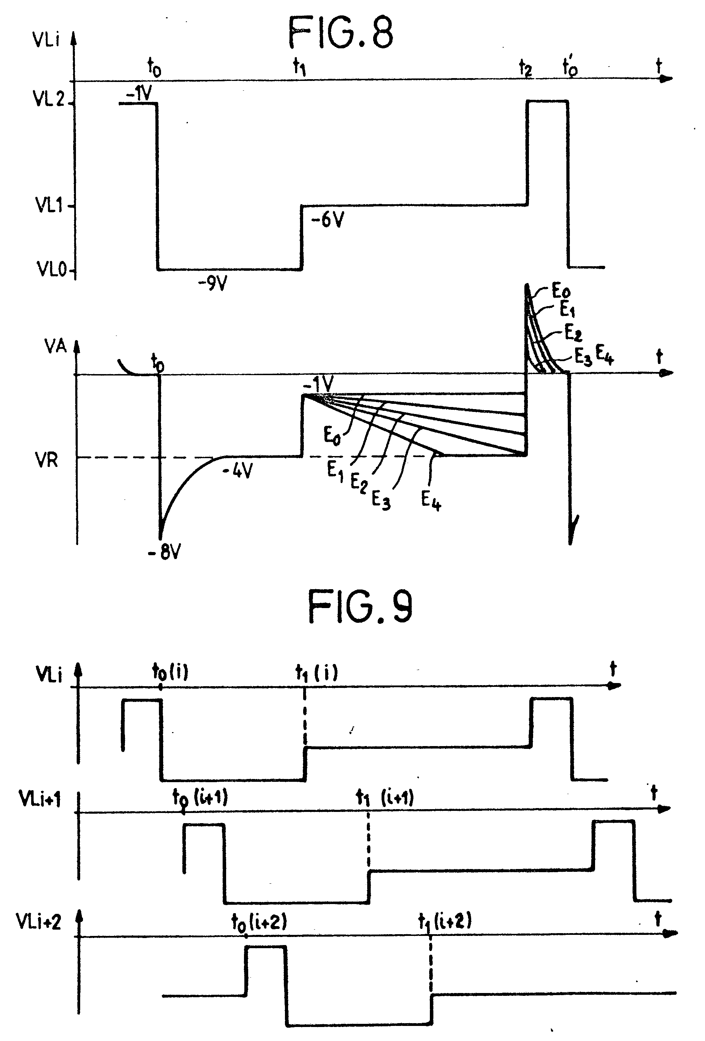

La figure 8 représente un diagramme temporel des variations de potentiel du point A d'abord entre un instant t0 de démarrage et un instant t'0 de fin d'un cycle d'intégration/lecture de charges/remise à niveau.

La tension de remise à niveau VR est négative, pour les polarités de diodes représentées, et en supposant que la référence de potentiel nul est le potentiel des conducteurs de colonne. Par exemple, VR = -4 volts.

Le cycle périodique de fonctionnement commence par une première phase de remise à niveau qui va de l'instant t0 à un instant t1. Pendant cette phase, le potentiel appliqué au conducteur de ligne Li a une première valeur VL0, par exemple -9 volts.

La deuxième phase est une phase d'intégration de charges pendant laquelle la photodiode éclairée accumule des charges (ici des électrons) sur le noeud flottant. Pendant cette phase, de l'instant t1 à l'instant t2, le potentiel du conducteur de ligne est porté à une valeur VL1 nettement supérieure à la tension VL0 mais telle que la différence VL1 - VL0 soit inférieure à la valeur absolue de la tension de référence VR. La différence VL1 - VL0 limitera la dynamique de mesure des charges, et il faut donc que cette différence soit suffisante. Par exemple, VL1 = -6 volts.

La troisième phase est une phase de lecture des charges stockées sur le noeud A. Pour cette phase, qui dure de l'instant t2 à l'instant t'0 de démarrage d'un nouveau cycle, le potentiel du conducteur de ligne Li est porté à une troisième valeur VL2 qui est de préférence telle que la différence VL2 - VL1 soit supérieure à la valeur absolue de VR. Ici, on choisit VL1 = -1 volt.

On suppose au départ que le potentiel VA du noeud A est nul. On verra que c'est bien à cet état de départ VA = 0 que l'on revient à la fin du cycle.

A l'instant t0 le potentiel du conducteur de ligne Li descend brusquement de la valeur VL2 à la valeur VL0. La variation de potentiel est donc de VL0 - VL2. Le potentiel du noeud A descend immédiatement d'autant (par couplage capacitif) et le potentiel du noeud A devient égal à VL0 - VL2.

Mais comme cette valeur est plus négative que la tension VR de remise à niveau, la diode DP devient conductrice et ramène à VR le potentiel du noeud A. C'est la phase de remise à niveau.

A l'instant t1, le potentiel du conducteur de ligne Li monte d'une valeur VL1 - VL0. Le potentiel du noeud A monte d'autant car d'une part aucune des diodes n'est polarisée en direct et d'autre part la capacité CS (par laquelle arrive l'impulsion de tension) est beaucoup plus forte que celle des diodes. Le potentiel du noeud A passe à la valeur VR + VL1 - VL0, dont on a précisé qu'elle était négative. La phase d'intégration de charges commence alors; les charges provenant de l'éclairement s'accumulent sur le noeud A et font baisser le potentiel de ce noeud. Il y a saturation si l'éclairement est suffisamment intense pour que le potentiel du noeud A descende au dessous de VR. La photodiode DP empêche en effet le potentiel de descendre au dessous de VR.

A l'instant t2 qui marque la fin de la phase d'intégration, le potentiel du noeud A a une valeur comprise entre :
VR + VL1 - VL0 si l'éclairement était nul (E0)
et VR si l'éclairement est supérieur (E4) ou égal (E3) à l'éclairement de saturation.

Le potentiel du conducteur de ligne Li passe alors à la valeur VL2. La variation de potentiel d'amplitude VL2 - VL1 est transmise au noeud A par couplage capacitif à travers la capacité CS. Le potentiel du noeud A s'accroît d'une valeur correspondante de sorte qu'il devient positif et rend la diode de lecture DL conductrice. Les charges stockées au point A sont évacuées sur le conducteur de colonne Cj qui les transmet au circuit de lecture CL.

L'excursion de tension VL2 - VL1 est choisie de préférence de manière que même en cas d'éclairement nul (VA = VR + VL1 -VL0 à l'instant t2), le potentiel du point A devienne positif; autrement dit, on prévoit de préférence que VL2 - VL1 est supérieur à la valeur absolue de la tension de remise à niveau VR (prise par rapport à la tension de référence de colonne). Ce choix a l'avantage de permettre la transmission d'une charge d'entrainement non nulle même pour un éclairement maximal, ce qui facilite la lecture des forts éclairements. Quant à la lecture des faibles éclairements elle est très facile puisqu'alors la charge à transmettre sur le conducteur de colonne est maximale.

La variation de la quantité de charges évacuée pendant l'impulsion de lecture (t2 à t'0) pour les différents niveaux d'éclairement envisagés (nul, moyen, de saturation) est exactement la même qu'à la figure 3.

L'impulsion de lecture doit avoir une durée suffisante pour permettre l'évacuation de toutes les charges stockées sur le noeud A, même pour le cas d'un éclairement nul.

A la fin de l'impulsion de lecture, la diode de lecture se trouve dans un état bloqué (tension nulle à ses bornes);le potentiel du conducteur de ligne repasse brusquement à sa valeur fortement négative VL0. La diminution brutale de tension se retransmet intégralement au noeud A qui descend à une tension VL0 - VL2, et un nouveau cycle commence.

La figure 9 montre comment les cycles de remise à niveau/intégration/lecture doivent être décalés dans le temps les uns par rapport aux autres.

Les impulsions de lecture sont décalées pour ne pas se recouvrir mutuellement, mais il n'est pas nécessaire d'attendre pour commencer une impulsion de lecture d'une ligne que la phase de remise à niveau de la ligne précédente soit terminée.

## Revendications

1. Matrice de points photosensibles comportant un réseau de points photosensibles (Pij) agencés en lignes (au moins une ligne) et en colonnes (au moins une colonne), chaque point photosensible étant situé au carrefour d'une ligne et d'une colonne, caractérisé en ce que chaque point photosensible comprend deux diodes (DP et DL) et une capacité (CS) reliées à un noeud flottant (A), la capacité étant reliée entre un conducteur de ligne (LLi) et le noeud flottant, une première diode (DL), dite diode de lecture, connectée entre le noeud flottant commun et un conducteur de colonne (Cj) pour permettre le transfert entre ce conducteur de colonne et le noeud flottant d'une quantité de charges générées sur le noeud flottant par l'éclairement du point photosensible, et une deuxième diode (DP), dite diode photosensible, connectée entre le noeud flottant et un conducteur (LRi) relié à une source de tension de remise à niveau, pour d'une part engendrer lorsqu'elle est éclairée des charges électriques sur le noeud flottant et d'autre part rétablir à une valeur choisie le potentiel du noeud flottant après ledit transfert de charges.

2. Matrice selon la revendication 1, caractérisée en ce que l'anode de la diode de lecture et la cathode de la diode photosensible sont reliées au noeud flottant, ou inversement la cathode de la diode de lecture et l'anode de la diode photosensible sont reliées au noeud flottant.

3. Matrice selon l'une des revendications 1 et 2, caractérisée en ce que la source de tension de remise à niveau est reliée à un autre conducteur de ligne (LRi), et en ce qu'il est prévu un moyen (DEL) pour appliquer sur le premier conducteur de ligne mentionné (LLi) une impulsion de lecture à la fin d'une période d'intégration de charges, et sur l'autre conducteur de ligne une impulsion de tension de remise à niveau suivant l'impulsion de lecture.

4. Matrice selon la revendication 3, caractérisée en ce que l'impulsion de lecture a une amplitude plus grande que l'impulsion de remise à niveau.

5. Matrice selon la revendication 3, caractérisée en ce que l'impulsion de lecture et l'impulsion de remise à niveau ont la même amplitude et les mêmes niveaux de potentiel haut et bas.

6. Matrice selon la revendication 5, caractérisée en ce que l'autre conducteur de ligne (LRi), relié à la photodiode d'un point photosensible d'une ligne déterminée, est le premier conducteur de ligne (LLi+1) relié à la capacité d'un point photosensible d'une autre ligne de la matrice.

7. Matrice selon l'une des revendications 2, caractérisée en ce que la source de tension de remise à niveau est une source de tension fixe (CVR).

8. Matrice selon la revendication 7, caractérisée en ce que la cathode de la diode photosensible et l'anode de la diode de lecture sont reliées au noeud commun, ou réciproquement que l'anode de la diode photosensible et la cathode de la diode de lecture sont reliées au noeud commun, et en ce qu'il est prévu au moyen pour appliquer sur le conducteur de ligne un cycle de variation de potentiel comprenant une première phase d'intégration de charges dans laquelle le potentiel du conducteur de ligne est à un premier niveau (VL1), une deuxième phase de lecture dans lequel le potentiel du conducteur de ligne est à un deuxième niveau (VL2), et une troisième phase de remise à niveau dans lequel le potentiel du conducteur de ligne est à un troisième niveau (VLO).

9. Matrice selon la revendication 8, caractérisée en ce que la différence de potentiel entre les premier et troisième niveaux est en valeur absolue inférieure à la différence de potentiel entre la source de tension de remise à niveau et un potentiel de référence des conducteurs de colonne.

10. Matrice selon la revendication 9, caractérisée en ce que la différence de potentiel entre les deuxième et premier niveaux est supérieure en valeur absolue à la différence de potentiel entre la source de tension de remise à niveau et un potentiel de référence des conducteurs de colonne.

11. Matrice selon l'une des revendications 1 à 10, caractérisée en ce qu'il est prévu un moyen pour appliquer sur le conducteur de ligne une impulsion de tension de lecture d'un premier signe par rapport à un potentiel de référence appliqué au conducteur de colonne pendant une phase d'intégration de charges, et simultanément avec l'impulsion de lecture, une impulsion de tension de sélection du signe opposé appliquée à un conducteur de colonne spécifié relié au point photosensible considéré, les autres conducteurs de colonne étant maintenus au potentiel de référence pendant cette impulsion de sélection.

# FIG.1

# FIG.2a

# FIG.2b

# FIG.2c

# FIG.3

# FIG.4a

# FIG.4b

# FIG.4c

# FIG.5

# FIG.6

# FIG.7

# FIG.8

# FIG.9

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | US-A-4 200 892 (WEIMER)<br>* Colonne 4, ligne 42 - colonne 5, ligne 27; figure 1D *<br>--- | 1 | H 04 N 3/15<br>H 01 L 27/14 |
| A | FR-A-2 593 987 (THOMSON-CSF)<br>* Page 16, lignes 15-21; figure 4 *<br>----- | 1 | |

DOMAINES TECHNIQUES
RECHERCHES (Int. Cl.4)

H 04 N
H 01 L

Le présent rapport a été établi pour toutes les revendications

| Lieu de la recherche | Date d'achèvement de la recherche | Examinateur |
|---|---|---|
| LA HAYE | 04-04-1989 | BEQUET T.P. |

EPO FORM 1503 03.82 (P0402)